# FASCICULE DE BREVET EUROPEEN

(11) **EP 2 292 553 B1**
(45) Date de publication et mention de la délivrance du brevet: **09.05.2012**
(21) Numéro de dépôt: 10174794.7
(22) Date de dépôt: 01.09.2010
(51) Int. Cl.: B81B 7/00

(54) **Dispositif et procédé d'encapsulation, microcapsule incorporant ce procédé**
Bauelement und Verfahren zur Herstellung einer Mikroverkapselung
Component and process for reversibly sealing a microcapsule package

(30) Priorité: 02.09.2009 FR 0955975
(43) Date de publication de la demande: 09.03.2011
(73) Titulaire: Commissariat à l'Énergie Atomique et aux Énergies Alternatives, 75015 Paris (FR)
(72) Inventeur: Hilt, Thierry, 38530, BARRAUX (FR); Baillin, Xavier, 38920, CROLLES (FR)
(74) Mandataire: Colombo, Michel

(56) Documents cités:
- WO-A2-03/095706
- FR-A1- 2 864 340
- US-A1- 2005 142 242

## Description

L'invention concerne un dispositif et un procédé d'encapsulation d'un élément à l'intérieur d'une microcavité ménagée sur un support. L'invention concerne également une microcapsule incorporant ce dispositif d'encapsulation.

Par microcavité on désigne ici une cavité dont la largeur est au plus de 1 ou 5 mm et dont la hauteur est au plus d'1 mm ou de 500 µm.

Par élément, on désigne ici aussi bien un microcomposant qu'une matière telle qu'un liquide ou un gaz.

Les microcomposants sont aussi bien des microsystèmes électromécaniques connus sous l'acronyme de MEMS (Microelectromechanical Systems) ou NEMS (Nanoelectromechanical Systems) que d'autres microcomposants tels que les microcomposants électroniques, optiques, optoélectroniques ou les biopuces. Les circuits intégrés sont également englobés dans la dénomination de microcomposants.

Les microcavités et microcomposants diffèrent des cavités ou composants macroscopiques en outre par leur procédé de fabrication. Ces microcavités et microcomposants sont réalisés en utilisant les mêmes procédés de fabrication collectifs que ceux utilisés pour réaliser les puces microélectroniques. Par exemples, les microcavités et microcomposants sont réalisés à partir de plaquettes, par exemple en silicium monocristallin ou en verre, usinées par photolithographie et gravure (par exemple DRIE (Deep Reactive Ion Etching)) et/ou structurées par croissance épitaxiale et dépôt de matériaux métalliques.

Grâce à ces procédés de fabrication les microcavités et microcomposants présentent généralement des parties usinées dont au moins une des dimensions est de l'ordre du micromètre. La dimension d'ordre micrométrique est généralement inférieure à 200 µm et, par exemple, comprise entre 1 et 200 µm.

Il est très souvent nécessaire de loger un élément à l'intérieur d'une microcavité pour l'isoler et le protéger de l'environnement extérieur. A cet effet, différents dispositifs d'encapsulation sont connus. Ces dispositifs connus comportent une membrane d'encapsulation apte à former au moins une partie de la microcavité.

Par exemple, un dispositif d'encapsulation peut être créé en utilisant un procédé d'encapsulation connu sous le terme de « packaging en couches minces » (PCM) ou « film packaging ». Il s'agit d'un procédé collectif d'encapsulation utilisant des techniques couramment utilisées pour la réalisation de microcomposants. Pour réaliser un dispositif d'encapsulation par le procédé PCM il faut notamment:
- réaliser le microcomposant sur un support,
- déposer une couche sacrificielle sur le microcomposant,
- déposer la membrane d'encapsulation sur la couche sacrificielle,
- percer des trous de libération dans la membrane d'encapsulation propres à permettre l'évacuation de la couche sacrificielle,
- retirer la couche sacrificielle par l'intermédiaire des trous de libération, et
- boucher les trous de libération pour fermer la microcavité créée par le retrait de la couche sacrificielle.

Dans un tel procédé de réalisation du dispositif d'encapsulation, il est nécessaire de percer des trous dans la membrane d'encapsulation. Ensuite, il est nécessaire de boucher ces trous ce qui peut polluer l'intérieur de la microcavité avec, par exemple, des résidus de matériau de bouchage des trous.

Un autre type de dispositif d'encapsulation est réalisé par report d'un capot sur le support. Le capot est usiné par les mêmes techniques que celles utilisées pour fabriquer le microcomposant. Le capot est usiné indépendamment du support à encapsuler. Ensuite, le capot est assemblé sur le support pour former la microcavité dans laquelle est reçu l'élément à encapsuler. Cette opération d'assemblage est complexe. En effet, par exemple, elle nécessite un positionnement précis du capot par rapport à l'élément à encapsuler puis un scellement du capot sur le support.

L'état de la technique présentée ci-dessus est décrit plus en détail dans le document D1 suivant:
J. L. Pornin & al, «Wafer Level Thin Film Encapsulation for BOW RF MEMS », CEA-LETI, Publié à 57th ECTC (Electronic Component and Technology Conference), juin 2007. De l'état de la technique est également connu de WO03/095706 A2, FR2 864 340 et US 2005/142242 A1.

L'invention vise à proposer un dispositif d'encapsulation plus simple à réaliser.

Elle a donc pour objet un dispositif d'encapsulation conforme à la revendication 1.

On entend par communication fluidique, tout échange de matière entre l'intérieur et l'extérieur de la cavité et, par exemple, d'un liquide, d'un gaz et/ou d'un plasma.

Grâce au dispositif ci-dessus, il n'est pas nécessaire de percer des trous de libération dans la membrane d'encapsulation. A la place, il suffit de déplacer la membrane d'encapsulation vers sa position d'ouverture pour mettre l'intérieur de la microcavité en communication fluidique avec l'extérieur. Puisque la membrane d'encapsulation n'est pas percée, il n'est pas non plus nécessaire de boucher des trous de libération. Les risques de pollution de l'intérieur de la microcavité par des résidus de matériau de bouchage sont donc éliminés.

Le dispositif ci-dessus ne nécessite pas non plus l'assemblage d'un capot réalisé indépendamment du support. En effet, pour fermer la microcavité, il suffit de déplacer la membrane d'encapsulation, qui est déjà fixée sur le support, vers sa position de fermeture. Cette opération de fermeture est beaucoup moins complexe que l'assemblage d'un capot indépendant sur le support.

Les modes de réalisation de ce dispositif d'encapsulation peuvent comporter une ou plusieurs des caractéristiques suivantes :
■ la membrane définit le toit de la microcavité dans la position de fermeture;
■ le dispositif comprend en outre des moyens d'actuation associés en partie à la membrane et en partie au support pour permettre le déplacement de la membrane entre ses positions d'ouverture et de fermeture ;
■ les moyens d'actuation sont choisis parmi des moyens thermiques, électrostatiques, électromagnétiques ou piézoélectriques seuls ou en combinaison ;
■ les moyens d'actuation thermique comprennent au moins le bras attachant la membrane d'encapsulation au support, ce bras comportant au moins deux couches, au moins en partie superposées, réalisées dans des matériaux dont les coefficients de dilatation sont différents pour que, en réponse à une variation de température, ce bras se courbe et entraîne le déplacement de la membrane d'encapsulation entre ses positions d'ouverture et de fermeture ou vice versa;
■ la membrane d'encapsulation comprend au moins deux couches superposées réalisées dans des matériaux dont les coefficients de dilatation sont choisis pour qu'à une température d'utilisation la membrane d'encapsulation soit bombée de manière à définir une paroi latérale et un toit de la microcavité dans laquelle est reçu l'élément ;
■ la membrane d'encapsulation comporte au moins deux couches superposées réalisées dans des matériaux, dont au moins un présente des propriétés piézoélectriques pour permettre, pour une différence donnée de potentiels appliquée audit matériau, que la membrane d'encapsulation soit bombée de manière à définir une paroi latérale et un toit de la microcavité dans laquelle est reçu l'élément ;
■ le matériau de la couche de la membrane d'encapsulation en contact avec la microcavité est en plus un matériau fixateur de gaz ;
■ le dispositif comprend au moins une électrode de chauffage du bras et/ou de la membrane d'encapsulation, solidaire du support ;
■ au moins l'une des couches du bras et/ou de la membrane d'encapsulation, réalisée dans un matériau présentant un coefficient de dilatation différent des matériaux des autres couches, est un matériau résistif propre à dissiper une énergie électrique sous forme de chaleur lorsqu'il est parcouru par un courant, cette couche formant ainsi l'électrode de chauffage, et le dispositif comprend des pistes conductrices raccordant électriquement la couche en matériau résistif à des bornes de raccordement d'une source de courant ;
■ la membrane d'encapsulation présente un bord circulaire centré sur un axe de révolution et les couches de la membrane d'encapsulation admettent comme axe de symétrie de rotation cet axe de révolution ;
■ la membrane d'encapsulation présente un bord polygonal et au moins une des couches de la membrane d'encapsulation est réalisée par :
   - un matériau anisotrope qui présente des coefficients de dilatation ou des propriétés piézoélectriques différents selon des directions différentes du plan de la membrane, ou
   - un matériau non uniformément réparti à l'intérieur de ladite couche,
ce matériau étant agencé dans la couche de manière à ce que le bord polygonal de la membrane d'encapsulation soit dans un plan dans la position de fermeture.

Les modes de réalisation du dispositif d'encapsulation présentent en outre les avantages suivants :
- utiliser un bras formé par la superposition de deux couches dont les coefficients de dilatation sont différents permet d'obtenir un mécanisme simple de déplacement de la membrane entre ses positions d'ouverture et de fermeture,
- la réalisation de la membrane à partir de matériaux dont les coefficients de dilatation sont différents permet de réaliser simplement une paroi latérale de la microcavité à partir d'une membrane d'encapsulation plane,
- utiliser un matériau pour réaliser l'une des couches de la membrane qui est en plus un matériau fixateur de gaz permet de réaliser à l'aide d'une même couche les fonctions de fixateur de gaz et de bilame,
- incorporer des électrodes de chauffage au bras ou à la membrane permet d'éviter d'avoir recours à des moyens de chauffage externes et indépendants du support,
- incorporer dans le bras ou la membrane une couche réalisée en matériau résistif raccordée à des bornes d'alimentation permet de réaliser simplement l'électrode de chauffage à partir de l'un des matériaux dont le coefficient de dilatation est différent des matériaux des autres couches,
- la symétrie de rotation des couches de la membrane permet d'obtenir une fermeture de la microcavité aussi étanche que possible sans avoir recours à des matériaux anisotropes,
- utiliser une membrane dont le bord est polygonal et dans un plan dans la position de fermeture permet de réaliser une microcavité dont la paroi latérale s'étend le long d'un périmètre polygonal tout en obtenant une fermeture de la microcavité aussi étanche que possible.

L'invention a également pour objet une microcapsule comportant un élément reçu à l'intérieur d'une microcavité et le dispositif d'encapsulation ci-dessus.

L'invention a également pour objet un procédé d'encapsulation conforme à la revendication 14.

Les modes de réalisation de ce procédé d'encapsulation peuvent comporter une ou plusieurs des caractéristiques suivantes :
■ le procédé comprend la modification de la température du bras attachant la membrane d'encapsulation au support pour qu'en réponse ce bras déplace la membrane d'encapsulation entre ses positions de fermeture et d'ouverture ;
■ le procédé comprend :
   - la réalisation de l'élément à encapsuler sur le support,
   - le dépôt d'une couche sacrificielle sur l'élément, puis
   - la réalisation de la membrane d'encapsulation sur la couche sacrificielle, puis
   - le retrait de la couche sacrificielle pour créer la microcavité dans laquelle est reçu l'élément et,
   - avant ou au cours du retrait de la couche sacrificielle, le déplacement de la membrane d'encapsulation vers sa position d'ouverture pour faciliter le retrait de la couche sacrificielle, et
   - après le retrait de la couche sacrificielle, l'action de courber le bras pour déplacer la membrane d'encapsulation vers sa position de fermeture

L'invention sera mieux comprise à la lecture de la description qui va suivre, donnée uniquement à titre d'exemple non limitatif, et faite en se référant aux dessins sur lesquels:
- les figures 1 et 2 sont des illustrations en coupe d'une microcapsule équipée d'un dispositif d'encapsulation,
- la figure 3 est une illustration schématique en vue de dessus de la microcapsule des figures 1 et 2,
- la figure 4 est un procédé d'encapsulation pour obtenir la microcapsule des figures 1 à 3,
- les figures 5 à 14 représentent plus en détail différentes étapes du procédé d'encapsulation,
- la figure 15 est une illustration schématique et en perspective d'une membrane d'encapsulation dans une conformation convexe,
- les figures 16 et 17 sont une illustration schématique d'un deuxième mode de réalisation d'un dispositif d'encapsulation, respectivement, en position d'ouverture et de fermeture,
- les figures 18 et 19 sont des illustrations schématiques d'un troisième mode de réalisation d'un dispositif d'encapsulation, respectivement, dans ses positions d'ouverture et de fermeture,
- la figure 20 est une illustration schématique d'un quatrième mode de réalisation d'un dispositif d'encapsulation, et
- la figure 21 est une illustration schématique d'un autre mode de réalisation possible d'une membrane d'encapsulation.

Dans ces figures, les mêmes références sont utilisées pour désigner les mêmes éléments.

Dans la suite de cette description, les caractéristiques et fonctions bien connues de l'homme du métier ne sont pas décrites en détail. En particulier, pour des compléments d'informations, il est possible de se référer, par exemple, au document D1.

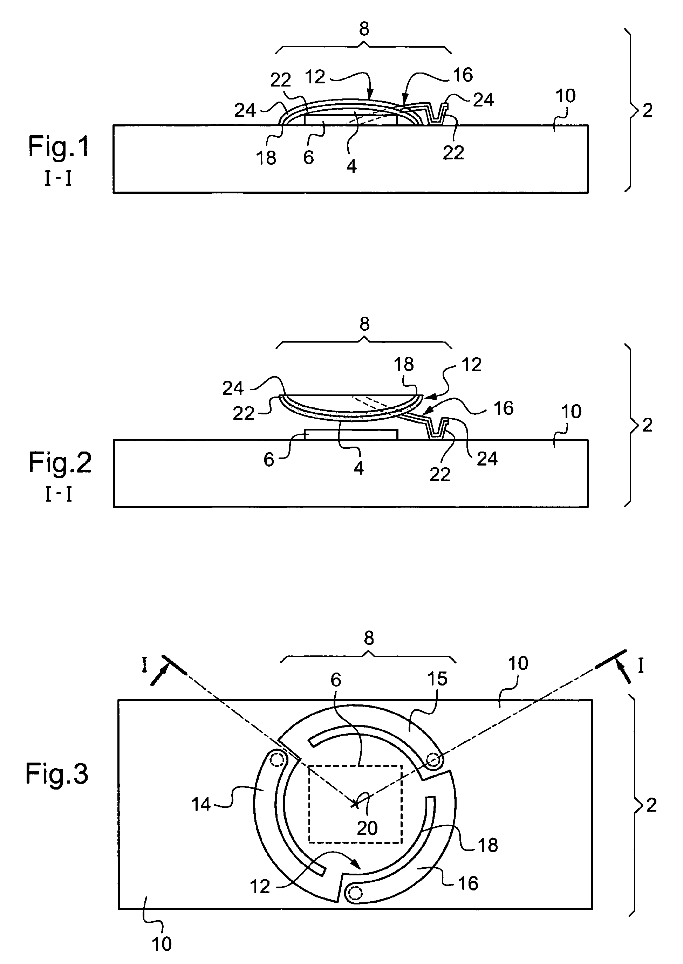

Les figures 1 à 3 représente une microcapsule 2 comprenant un élément encapsulé dans une microcavité 4. Les figures 1 et 2 sont une coupe verticale selon la ligne I-I de la figure 3.

La microcapsule 2 est décrite ici dans le cas particulier où l'élément est un microcomposant 6 tel qu'un MEMS.

La microcapsule 2 comprend un dispositif 8 d'encapsulation du microcomposant 6 dans la microcavité 4.

Le dispositif 8 comprend :
- un support 10,
- une membrane d'encapsulation 12, et
- des bras 14 à 16 de fixation de la membrane 12 sur le support 10.

Le support 10 présente une face supérieure horizontale sur laquelle est fixée le microcomposant 6. A titre d'exemple, le support 10 est réalisé en silicium ou en verre.

Ici, la membrane 12 a la forme d'un disque présentant un bord circulaire 18 centré sur un axe 20 de révolution. L'axe 20 est perpendiculaire à la face supérieure du support 10. L'axe 20 est centré sur le microcomposant 6 à encapsuler. Par exemple, l'axe 20 passe par le centre de masse du microcomposant 6.

La membrane 12 est directement et en permanence fixée sur le support 10 par les trois bras 14 à 16. Chaque bras présente une première et une seconde extrémités directement raccordées mécaniquement, respectivement, au bord 18 et au support 10. Les première et seconde extrémités s'étendent, respectivement, essentiellement horizontalement et verticalement.

La membrane 12 est déplaçable entre :
- une position d'ouverture (figure 2) dans laquelle l'intérieur de la microcavité 4 est en communication fluidique avec l'extérieur de la microcavité par l'intermédiaire d'une ouverture, et
- une position de fermeture dans laquelle la membrane 12 d'encapsulation obstrue cette ouverture.

Dans la position d'ouverture, la membrane 12 surplombe l'élément 6 et sa périphérie, c'est-à-dire ici son bord 18, définit avec le support 10 une ouverture qui s'étend autour de l'élément 6. Ici, on considère que l'ouverture s'étend autour de l'élément 6 si la projection orthogonale de la périphérie de la membrane sur le support 10 entoure, de préférence complètement, l'élément 6.

Pour cela, les bras 14 à 16 jouent le rôle de moyens d'actuation des déplacements de la membrane 12 entre ses positions d'ouverture et de fermeture.

De plus, la membrane 12 est déformable entre :
- une conformation concave bombée vers l'intérieur (figure 1) dans laquelle son bord 18 est tourné vers le support 10, et
- une conformation convexe bombée vers l'extérieur (figure 2) dans laquelle son bord 18 est tourné du côté opposé.

Dans la conformation concave, la membrane 12 définit la paroi latérale et le toit de la microcavité 4.

Dans ce mode de réalisation, le déplacement de la membrane 12 entre les positions de fermeture et d'ouverture et le passage de la membrane entre les conformations concave et convexe sont actionnés simultanément par une même variation de température. La position de fermeture et la conformation concave sont atteintes pour une température de fermeture. Par exemple, la température de fermeture est inférieure à 25°C. La position d'ouverture et la conformation convexe sont atteintes pour une température d'ouverture supérieure d'au moins 50°C à la température de fermeture. Par exemple, la température d'ouverture est supérieure à 200°C ou 250°C.

Pour cela, la membrane 12 comme les bras 14 à 16 se comportent à la façon d'un bilame. Ils sont réalisés par la superposition de plusieurs couches réalisées chacune dans un matériau dont le coefficient de dilatation est différent de celui des autres couches. Dans ce mode de réalisation, les matériaux utilisés sont des matériaux isotropes, c'est-à-dire que leur coefficient de dilatation thermique est le même quelle que soit la direction considérée. De plus, chaque matériau est uniformément réparti dans la couche qu'il constitue. Ainsi, les couches sont des couches pleines.

Ici, les coefficients de dilatation des matériaux de chaque couche vont en diminuant au fur et à mesure qu'on s'éloigne du microcomposant 6.

La membrane 12 est hermétique au fluide à emprisonner dans la microcavité 4. Par exemple, la membrane 12 est hermétique au gaz tel que l'hélium. Ici, ce sont les matériaux des couches qui permettent d'atteindre ce degré d'herméticité.

A titre d'illustration, la membrane 12 et les bras 14 à 16 sont composés de seulement deux couches superposées 22 et 24. Ces couches sont des couches métalliques. Par exemple, la couche 22, la plus proche du microcomposant 6, est réalisée en titane. La couche 24 qui est empilée sur la couche 22 est réalisée en zirconium.

Ces matériaux, en plus de présenter des coefficients de dilatation différents sont également des matériaux fixateurs de gaz plus connus sous le terme anglais de « getter ». Ces matériaux, lorsqu'ils sont activés, présentent donc la propriété d'absorber le gaz contenu dans la microcavité 4 ce qui permet de réaliser le vide à l'intérieur de cette microcavité lorsque celle-ci est hermétiquement scellée.

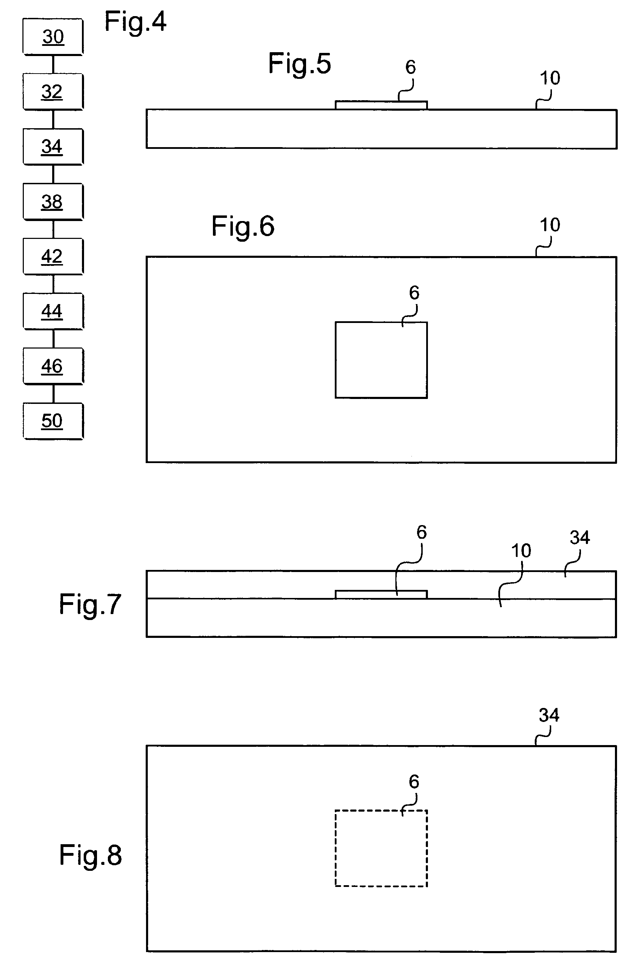

La figure 4 représente un procédé d'encapsulation d'un élément à l'intérieur d'une microcavité pour former la microcapsule 2.

Initialement, lors d'une étape 30, le microcomposant 6 est réalisé sur le support 10. Cette étape est réalisée à l'aide de procédé classique de fabrication de microcomposants. Cette étape comprend également, si nécessaire, une étape d'isolation électrique du microcomposant 6 par rapport au support 10.

Les figures 5 et 6 représentent le produit obtenu l'issue de l'étape 30, respectivement, en vue de côté et en vue de dessus.

Ensuite, lors d'une étape 32, une couche sacrificielle 34 (figure 7) est déposée sur l'ensemble de la surface du microcomposant 6 et du support 10. Par exemple, cette couche sacrificielle 34 est une couche en résine photosensible positive. L'épaisseur de cette couche 34 est de quelques micromètres. Par exemple son épaisseur est inférieure ou égale à 2 µm.

Les figures 7 et 8 représentent le produit obtenu à l'issu de l'étape 32, respectivement en vue de côté et en vue de dessus.

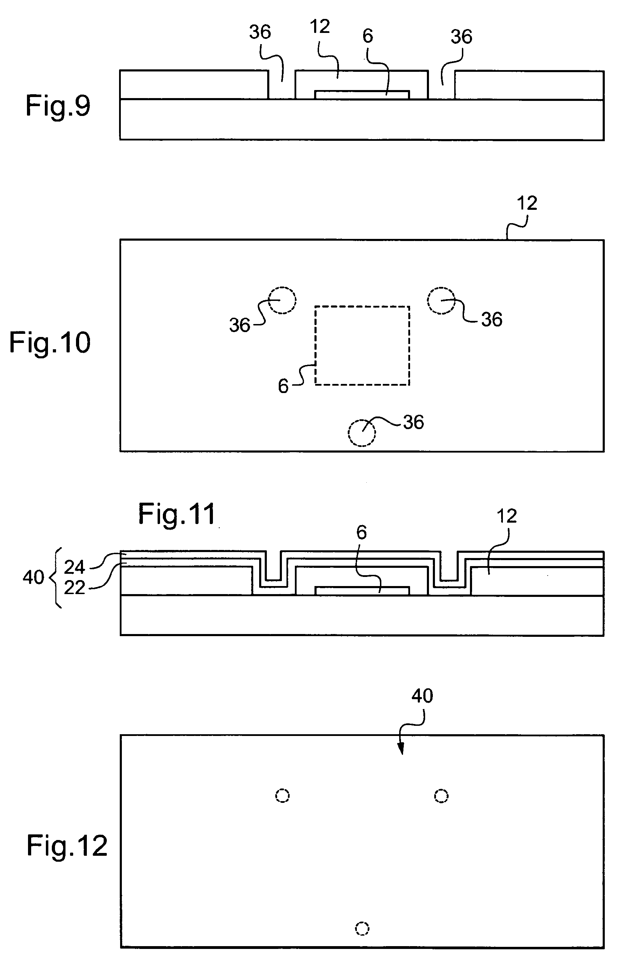

Ensuite, lors d'une étape 34, des puits 36 (figure 9) pour fixer des bras 14 à 16 sur le support 10 sont creusés dans la couche sacrificielle 34. Les puits 36 sont creusés jusqu'à la face supérieure du support 10. Par exemple, pour cela, on procède à une opération d'insolation de la couche sacrificielle 34 suivie par une opération de développement.

Les figures 9 et 10 représentent le produit obtenu à l'issu de l'étape 34, respectivement, en vue de côté et en vue de dessus.

Ensuite, lors d'une étape 38, un film 40 (figure 11) est déposé sur toute la surface de la couche sacrificielle 34. Ce film 40 est également déposé sur le fond et les parois latérales des puits 36. Le film 40 est donc fixé directement sur le support 10 à travers la couche 34.

Le film 40 est composé des couches 22 et 24. Les différentes couches du film 40 sont déposées à une température intermédiaire entre les températures d'ouverture et de fermeture. De préférence, la température intermédiaire est égale à la moyenne des températures d'ouverture et de fermeture à plus ou moins 20% prêt. Par exemple, le dépôt des couches du film 40 se fait à une température proche de 125°C.

Les figures 11 et 12 représentent le produit obtenu à l'issu de l'étape 38, respectivement, en coupe de côté et en vue de dessus.

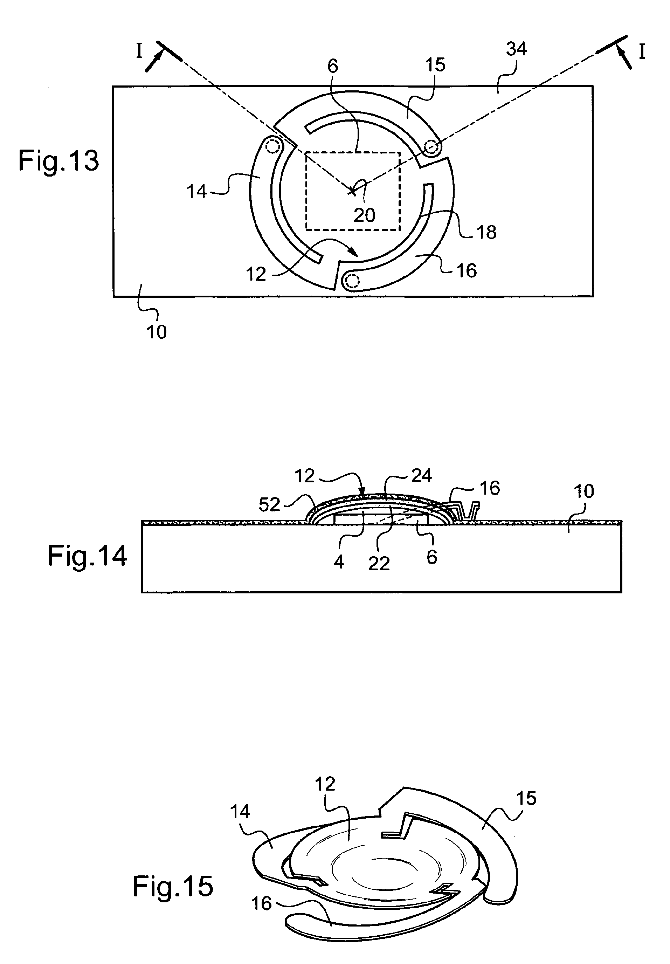

Une fois le film 40 déposé, lors d'une étape 42, celui-ci est gravé pour réaliser la membrane 12 et les bras 14 à 16. Le résultat obtenu est représenté en vue de dessus sur la figure 13.

Le film 40 est par exemple gravé à l'aide de procédés conventionnels tels que la lithographie et la gravure de métaux.

Ensuite, lors d'une étape 44, on procède au retrait de la couche sacrificielle 34. Cette étape est réalisée à la température d'ouverture. Ainsi, le dispositif d'encapsulation est en même temps déplacé vers la position d'ouverture représentée sur la figure 2. Toutefois, sur la figure 2 la couche sacrificielle 34 en cours de retrait n'est pas représentée.

La couche sacrificielle peut être retirée par attaque plasma ou par d'autres procédés tels qu'une attaque chimique. Ici, lors de l'étape 44, la couche sacrificielle 34 est retirée par attaque plasma. L'attaque plasma échauffe le dispositif 8 d'encapsulation. Typiquement, lors de cette étape 44, la température atteint plus de 200 ou 250 °C. A cause de cet échauffement, la couche 22 se dilate plus que la couche 24 de sorte que la membrane 12 adopte la conformation convexe. La conformation convexe est également représentée en perspective sur la figure 15. Toutefois, sur cette figure, pour la simplifier, seule les premières extrémités des bras 14 à 16 ont été représentées.

De plus, cette élévation de température conduit également les bras 14 à 16 à se courber pour éloigner la membrane 12 du microcomposant 6.

Dans la position d'ouverture, la membrane 12 ménage de grandes ouvertures situées entre son bord 18 et le support 10 qui facilitent le retrait de la couche sacrificielle 34.

Une fois la couche sacrificielle retirée, lors d'une étape 46, la membrane 12 est déplacée de sa position d'ouverture vers sa position de fermeture et de sa conformation convexe vers sa conformation concave.

Pour déplacer la membrane 12 jusqu'à sa position de fermeture, la température est diminuée jusqu'à la température de fermeture. A cette température, la couche 22 se rétracte plus que la couche 24 ce qui conduit la membrane 12 à adopter la conformation concave. En même temps, les bras 14 à 16 se courbent pour déplacer la membrane 12 jusqu'à ce que le bord 18 soit directement en appui sur la face supérieure du support 10.

La microcavité 4 est obtenue sans qu'il soit nécessaire de procéder, comme dans les procédés connus, à la cuisson d'une résine photosensible pour obtenir cette conformation concave de la membrane d'encapsulation. Le fait de ne pas avoir à cuire la couche sacrificielle facilite également son retrait lors de l'étape 44.

Une fois la membrane 12 dans sa position de fermeture et dans sa conformation concave, la microcavité 4 est définitivement scellée, lors d'une étape 50. Par exemple, pour cela, on dépose sur la face extérieure du support 10 et de la membrane 12 une couche 52 (figure 14) de scellement qui permet de sceller de façon hermétique la microcavité 4. Par exemple, la couche 52 est réalisée dans un matériau hermétique à l'hélium.

De préférence, le matériau choisi pour réaliser la couche 52 présente également une forte rigidité mécanique de manière à accroître la rigidité mécanique des parois formant la microcavité 4. Par exemple, il s'agira d'une couche métallique. Cette couche métallique peut être déposée par dépôt chimique ECD (Electrochemical Deposit) ou en deux étapes. La première étape consiste à pulvériser le matériau métallique sur la surface extérieure de la membrane 12 du support 10. La seconde étape consiste à faire croître le matériau métallique par croissance électrolytique.

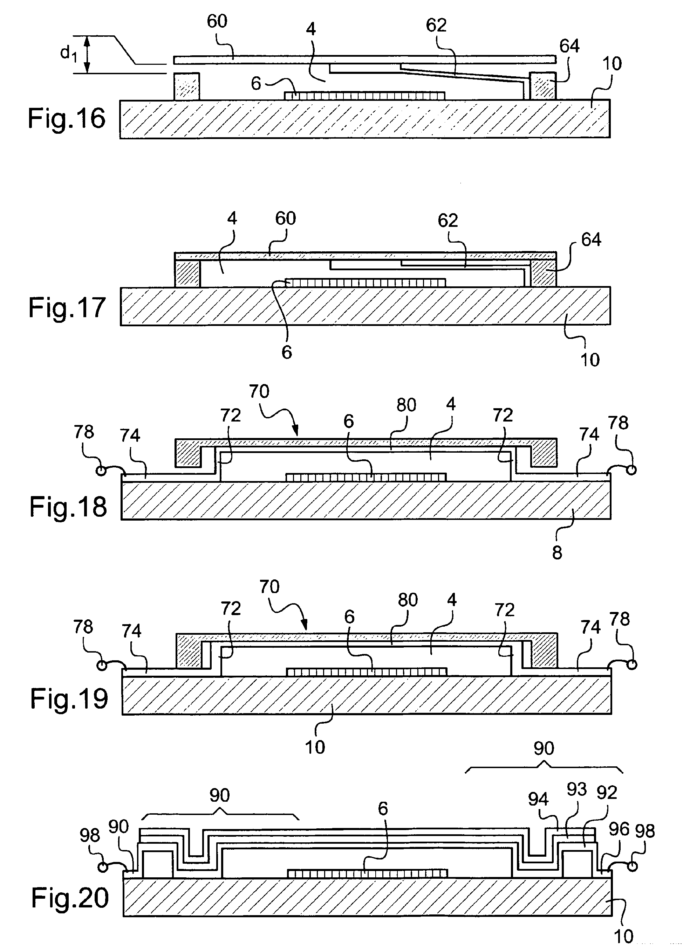

De nombreux autres modes de réalisation sont possibles. Par exemple, les figures 16 et 17 représentent un mode de réalisation dans lequel la membrane 12 et les bras 14 à 16 sont remplacés, respectivement, par une membrane 60, un ou plusieurs bras 62 et une paroi 64 entourant le microcomposant 6. Pour simplifier les figures 16 et 17, un seul bras 62 est représenté.

La paroi 64 s'étend essentiellement verticalement pour former un mur vertical entourant le microcomposant 6. La base de la paroi 64 est hermétiquement fixée sans aucun degré de liberté sur le support 10. La paroi 64 ne se courbe pas en réponse à des changements de température. A cet effet, elle est réalisée dans un seul et même matériau. La paroi 64 fait partie du support 10.

La membrane 60 est plane et s'étend essentiellement dans un plan horizontal. Ici, la membrane 60 ne se courbe pas en réponse à des changements de température. Par exemple, la membrane 60 est entièrement réalisée dans le même matériau. Le matériau utilisé pour la membrane 60 est le même que celui utilisé pour réaliser la paroi latérale 64.

La membrane 60 est fixée au support 10 par l'intermédiaire du bras 62. Ce bras 62 comporte plusieurs couches superposées les unes au-dessus des autres réalisées dans des matériaux de coefficients de dilatation différents de manière à se courber en réponse à un changement de température. Le bras 62 est conformé de manière à déplacer la membrane 60 entre une position d'ouverture (figure 16) et une position de fermeture (figure 17) en réponse à une variation de température. Dans la position d'ouverture, la membrane 60 est espacée de la paroi 64 par une distance d₁ de manière à ménager une ouverture mettant en communication fluidique l'intérieur de la microcavité 4 avec l'extérieur. Cette ouverture entoure l'élément 6. Dans la position de fermeture, le bras 62 se déforme de manière à amener la membrane 60 en appui sur la partie supérieure de la paroi 64 et donc en appui sur le support. Dans cette position, l'espace de largeur d₁ est rattrapé et la microcavité 4 est fermée.

Si un scellement définitif et hermétique est souhaité, dans la position de fermeture, une couche de scellement, telle que la couche 52, est déposée sur la membrane 60 et sur le support 10.

Dans ce mode de réalisation il n'est pas nécessaire que la membrane 60 se courbe de manière à former la paroi latérale de la microcavité 4. Toutefois, cela peut aussi être le cas en complément de la paroi 64.

Les déplacements de la membrane d'encapsulation peuvent être actionnés par d'autres moyens d'actuation. Par exemple, les figures 18 et 19 représentent un mode de réalisation dans lequel la membrane 12 et les pieds 14 à 16 sont respectivement remplacés par une membrane 70 et des pieds 72 réalisés en matériau piézoélectrique.

Dans ce mode de réalisation, la membrane 70 est déplaçable entre une position d'ouverture (figure 18) et une position de fermeture (figure 19) en réponse à la déformation des bras 72. Ici, la déformation des bras 72 consiste à les allonger plus ou moins dans la direction verticale. Pour simplifier les figures 18 et 19, seuls deux bras 72 ont été représentés.

Ici, la déformation des bras 72 est contrôlée en appliquant une différence de tension entre les extrémités de ces bras. A cet effet, les extrémités inférieures des bras 72 sont raccordées à des pistes conductrices 74 dont les extrémités sont elles-mêmes raccordées à des bornes 78 de raccordement d'une source d'alimentation. Les extrémités supérieures des bras 72 sont quant à elles raccordées électriquement l'une à l'autre par l'intermédiaire d'une piste 80 solidaire de la membrane 70.

Dans ce mode de réalisation, la membrane 70 ne se courbe pas en réponse aux variations de température. Elle est par exemple réalisée dans un seul et même matériau. Ici, la membrane 70 est conformée pour définir à la fois le toit et la paroi latérale de la microcavité 4.

Dans un autre mode de réalisation, les bras 72 sont remplacés par des bras comportant au moins deux couches au moins en partie superposées. Le matériau d'au moins l'une de ces couches présente des propriétés piézoélectriques pour permettre la création de contraintes mécaniques en réponse à l'application d'une différence de potentiels sur ce matériau. Ces contraintes mécaniques permettent de déplacer la membrane entre ses positions d'ouverture et de fermeture. Par exemple, ces contraintes mécaniques courbent le bras 72.

Il est également possible de remplacer la membrane 70 par une membrane comportant au moins une couche en matériau piézoélectrique de sorte qu'en réponse à l'application d'une différence de potentiels celle-ci se bombe pour former le toit et au moins une partie de la paroi latérale de la microcavité 4. Par exemple, la membrane comporte au moins deux couches superposées dont au moins une est réalisée dans un matériau présentant des propriétés piézoélectriques.

La figure 20 représente un mode de réalisation particulier dans lequel les bras sont composés d'un empilement de plus de deux couches. Pour simplifier la figure 20, la membrane d'encapsulation n'a pas été représentée et seuls deux bras 90 sont schématiquement illustrés en coupe à droite et à gauche du microcomposant 6. Ces bras 90 sont ici composés par l'empilement de trois couches successives 92, 93 et 94. Les coefficients de dilatation des couches 92 à 94 vont en augmentant au fur et à mesure que l'on s'éloigne du microcomposant 6. Un tel mode de réalisation permet de limiter les contraintes de cisaillement existant au niveau de l'interface entre chacune de ces couches 92 à 94.

De plus, ici, au moins l'une des couches est réalisée dans un matériau résistif propre à s'échauffer lorsqu'elle est parcourue par un courant électrique. Cette couche remplit alors en plus la fonction d'électrode de chauffage. Par exemple, la couche 92 est réalisée dans ce matériau résistif. A cet effet, cette couche 92 est raccordée par l'intermédiaire de pistes 96 à des bornes 98 de raccordement d'une source d'alimentation. Ainsi, pour actionner les bras 90, il suffit de faire passer un courant électrique dans la couche résistive 92.

En variante, la couche 92 ne participe pas au fonctionnement du bilame. Dans ce cas, le coefficient de dilatation du matériau de la couche 92 est identique ou très proche du coefficient de dilation du matériau de la couche 93. Cette couche 92 remplit donc seulement la fonction d'électrode de chauffage du bras 90.

Ainsi, dans le mode de réalisation de la figure 20, il n'est pas nécessaire d'élever la température de l'ensemble de l'environnement des bras 90 pour obtenir le déplacement de la membrane d'encapsulation entre ses positions d'ouverture et de fermeture.

La couche en matériau résistif peut également être incorporé dans la membrane d'encapsulation de manière à former une électrode de chauffage de cette membrane d'encapsulation.

De nombreux autres modes de réalisation des moyens d'actuation des déplacements de la membrane entre ses positions d'ouverture et de fermeture sont possibles. De préférence, ces moyens sont au moins en partie incorporés aux bras d'actuation. Par exemple, les déplacements sont actionnés de façon électrostatique. Dans un tel mode de réalisation, une électrode, fixée sur la membrane ou les bras, est disposée au moins en partie en vis-à-vis d'une autre électrode fixée sur le support 10. En modifiant la polarité de ces électrodes à partir d'une source d'alimentation, il est possible d'exercer une force de répulsion ou d'attraction qui permet de déplacer la membrane entre ses positions d'ouverture et de fermeture. Par exemple, une différence de potentiels est appliquée entre ces électrodes pour polariser les électrodes.

Dans un autre mode de réalisation, des moyens d'actuation magnétique sont utilisés pour déplacer la membrane. Par exemple, les moyens d'actuation comporte au moins une électrode disposée sur le bras de la membrane et des moyens d'induction magnétique disposés sur le support au moins en partie en regard de l'électrode. Les moyens d'inductions créent un champ magnétique permettant de déplacer la membrane entre ces positions d'ouverture et de fermeture. Il est également possible d'inverser les positions de l'électrode et des moyens d'induction. Dans ce dernier cas, les moyens d'induction sont portés par les bras.

Les moyens d'actuation peuvent également être réalisés à partir d'aimants. Par exemple, des aimants permanents de polarités opposées et en vis-à-vis l'un de l'autre sont fixés, d'un côté, sur la membrane et/ou le bras et, de l'autre côté, sur le support 10. Pour attirer ou repousser ces aimants on pourra jouer sur le fait que ces aimants perdent leurs aimantations au-delà de leurs températures de Curie respectives.

La membrane d'encapsulation peut également être déplacée entre ses positions d'ouverture et de fermeture par des bras réalisés dans des matériaux à mémoire de formes. Ainsi, dans ce mode de réalisation, c'est la mémoire de forme des matériaux qui est utilisée pour actionner le déplacement de la membrane plutôt qu'une différence de coefficients de dilatation. Le basculement d'une forme du matériau à une autre peut être commandé par un changement de température.

Il n'est pas systématiquement nécessaire que l'extrémité verticale des bras se courbe ou se déforme. Ainsi, cette extrémité verticale peut être réalisée différemment de l'extrémité horizontale. Par exemple, l'extrémité verticale est réalisée dans un seul matériau.

Il n'est pas indispensable que la ou les couches de la membrane d'encapsulation soient réalisées dans un matériau fixateur de gaz.

Il n'est pas non plus nécessaire que le matériau de chaque couche soit uniformément répandu à l'intérieur de cette couche.

Dans d'autres modes de réalisation, la membrane a un bord polygonal pour réaliser une paroi latérale de la microcavité s'étendant le long d'un périmètre polygonal. Pour obtenir une fermeture aussi hermétique que possible, le bord de la membrane d'encapsulation doit cependant être dans un même plan parallèle à la face supérieure du support dans la position de fermeture. Cela impose que les distances de dilatation ne sont pas les mêmes selon toutes les directions du plan de la membrane d'encapsulation. Pour cela, plusieurs solutions sont possibles. Premièrement, le matériau utilisé pour réaliser une ou plusieurs couches de la membrane d'encapsulation présente une anisotropie de leur coefficient de dilatation. De telle matériau anisotrope présente un coefficient de dilation différent selon la direction considérée. Par exemple, un matériau peut être orthotrope, c'est-à-dire qu'il présente seulement deux directions orthogonales le long desquelles son coefficient de dilatation diffère. Un matériau orthotrope peut être utilisé pour réaliser une ou plusieurs couches d'une membrane d'encapsulation rectangulaire. Dans ce mode de réalisation, la direction de plus forte dilatation du matériau est parallèle au plus petit côté et la direction de moins forte dilatation est parallèle au plus grand côté. Ainsi, dans la position de fermeture, le bord de la membrane d'encapsulation est dans un plan en contact avec la face supérieure du support.

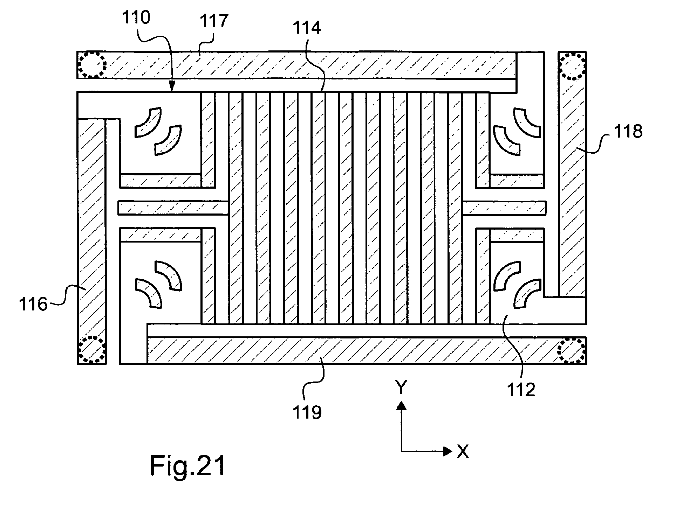

Une seconde solution consiste à utiliser un matériau isotrope non uniformément répandu dans une ou plusieurs couches de la membrane d'encapsulation. La figure 21 représente une membrane d'encapsulation 110 réalisée conformément à cette seconde solution. La membrane 110 est rectangulaire. Ses plus grand et plus petit côtés s'étendent, respectivement, parallèlement à des directions X et Y. La membrane 110 comprend une couche 112 réalisée à l'aide d'un matériau isotrope. Le matériau isotrope est uniformément répandu dans la couche 112 et forme donc une couche pleine. Sur cette couche 112 est superposée une couche 114 (représentée en hachuré sur la figure 21). La couche 114 est réalisée à l'aide d'un matériau isotrope non uniformément répandu dans la couche 114. Ici, la couche 114 est ajourée à certains endroits. Ces ajours rendent la dilatation de la couche 114 non identique dans les directions X et Y. Les ajours réalisés dans la couche 114 sont dimensionnés et positionnés de manière à ce que le bord rectangulaire de la membrane d'encapsulation soit dans un plan dans la position de fermeture.

Sur la figure 21, seules les premières extrémités de quatre bras 116 à 119 de fixation de la membrane 110 sur un support ont été représentés.

Suivant les applications visées, l'étape 50 de scellement hermétique de la microcavité est ou n'est pas réalisée. Ce scellement vise notamment à assurer une fermeture hermétique au fluide contenu dans la microcavité. En particulier, il s'agit de sceller hermétiquement la zone de contact entre la périphérie de la membrane et le support Ce scellement hermétique peut être réalisé de nombreuses façons différentes. Par exemple, une couche de Titane ou de résine polymère ou d'autre matière hermétique peut être déposée sur la membrane pour assurer ce scellement hermétique.

Le dispositif d'encapsulation a été décrit dans le cas particulier où un microcomposant est encapsulé. Toutefois, toutes sortes d'éléments peuvent être encapsulés dans la microcavité ainsi formée par le dispositif d'encapsulation. En particulier, des liquides peuvent être encapsulés à l'aide de ce dispositif d'encapsulation. Pour cela, une fois le dispositif d'encapsulation réalisé conformément au procédé de la figure 1, l'ensemble du dispositif est trempé dans le liquide à encapsuler puis la membrane est déplacée de sa position d'ouverture vers sa position de fermeture de façon à encapsuler une fraction du liquide à l'intérieur de la microcavité.

## Revendications

1. Dispositif d'encapsulation d'un élément à l'intérieur d'une microcavité ménagée sur un support (10), ce dispositif comprenant une membrane (12 ; 60 ; 70 ; 110) d'encapsulation apte à fermer au moins une partie de la microcavité,
**caractérisé en ce que** le dispositif comprend au moins un bras attachant mécaniquement la membrane au support, ce bras étant apte à se courber pour déplacer la membrane entre :
- une position d'ouverture dans laquelle la membrane surplombe l'élément à encapsuler et sa périphérie définit une ouverture qui s'étend autour de l'élément à encapsuler, et
- une position de fermeture dans laquelle la périphérie de la membrane d'encapsulation est en appui sur le support pour obstruer cette ouverture.

2. Dispositif selon la revendication 1, dans lequel la membrane définit le toit de la microcavité dans la position de fermeture.

3. Dispositif selon la revendication 1 ou 2, dans lequel le dispositif comprend en outre des moyens d'actuation, (14-16 ; 62 ; 72 ; 90 ; 116-119) associés en partie à la membrane (12 ; 60 ; 70 ; 110) et en partie au support (10) pour permettre le déplacement de la membrane entre ses positions d'ouverture et de fermeture.

4. Dispositif selon la revendication 3, dans lequel les moyens d'actuation (14-16 ; 62 ; 72 ; 90 ; 116-119) sont choisis parmi des moyens thermiques, électrostatiques, électromagnétiques ou piézoélectriques seuls ou en combinaison.

5. Dispositif selon la revendication 4, dans lequel les moyens d'actuation thermique comprennent au moins le bras (14-16 ; 62 ; 90 ; 116-119) attachant la membrane (12 ; 60 ; 70 ; 110) d'encapsulation au support, ce bras comportant au moins deux couches (22, 24), au moins en partie superposées, réalisées dans des matériaux dont les coefficients de dilatation sont différents pour que, en réponse à une variation de température, ce bras se courbe et entraîne le déplacement de la membrane d'encapsulation entre ses positions d'ouverture et de fermeture ou vice versa.

6. Dispositif selon l'une quelconque des revendications précédentes, dans lequel la membrane (12 ; 110) d'encapsulation comprend au moins deux couches (22, 24 ; 112, 114) superposées réalisées dans des matériaux dont les coefficients de dilatation sont choisis pour qu'à une température d'utilisation la membrane d'encapsulation soit bombée de manière à définir une paroi latérale et un toit de la microcavité dans laquelle est reçu l'élément.

7. Dispositif selon l'une quelconque des revendications précédentes, dans lequel la membrane d'encapsulation comporte au moins deux couches superposées réalisées dans des matériaux, dont au moins un présente des propriétés piézoélectriques pour permettre, pour une différence donnée de potentiels appliquée audit matériau, que la membrane d'encapsulation soit bombée de manière à définir une paroi latérale et un toit de la microcavité dans laquelle est reçu l'élément.

8. Dispositif selon la revendication 6 ou 7, dans lequel le matériau de la couche (22) de la membrane (10) d'encapsulation en contact avec la microcavité est en plus un matériau fixateur de gaz.

9. Dispositif selon l'une quelconque des revendication 5 à 8, dans lequel le dispositif comprend au moins une électrode de chauffage du bras et/ou de la membrane d'encapsulation, solidaire du support.

10. Dispositif selon la revendication 9, dans lequel :
- au moins l'une des couches (92) du bras et/ou de la membrane d'encapsulation, réalisée dans un matériau présentant un coefficient de dilatation différent des matériaux des autres couches, est un matériau résistif propre à dissiper une énergie électrique sous forme de chaleur lorsqu'il est parcouru par un courant, cette couche formant ainsi l'électrode de chauffage, et
- le dispositif comprend des pistes (96) conductrices raccordant électriquement la couche en matériau résistif à des bornes de raccordement d'une source de courant.

11. Dispositif selon l'une quelconque des revendications 6 à 10, dans lequel la membrane d'encapsulation (12) présente un bord circulaire (18) centré sur un axe (20) de révolution et les couches (22, 24) de la membrane d'encapsulation admettent comme axe de symétrie de rotation cet axe de révolution.

12. Dispositif selon l'une quelconque des revendications 6 à 10, dans lequel la membrane d'encapsulation (110) présente un bord polygonal et au moins une des couches (114) de la membrane d'encapsulation est réalisée par :
- un matériau anisotrope qui présente des coefficients de dilatation ou des propriétés piézoélectriques différents selon des directions différentes du plan de la membrane, ou
- un matériau non uniformément réparti à l'intérieur de ladite couche,
ce matériau étant agencé dans la couche de manière à ce que le bord polygonal de la membrane d'encapsulation soit dans un plan dans la position de fermeture.

13. Microcapsule comportant un élément (6) reçu à l'intérieur d'une microcavité (4), **caractérisé en ce que** la microcapsule comporte également un dispositif (8) d'encapsulation conforme à l'une quelconque des revendications précédentes.

14. Procédé d'encapsulation d'un élément à l'intérieur d'une microcavité ménagée sur un support, **caractérisé en ce que** ce procédé comprend l'action de courber (46) au moins un bras attachant mécaniquement une membrane d'encapsulation au support pour déplacer la membrane d'encapsulation entre :
- une position d'ouverture dans laquelle la membrane surplombe l'élément à encapsuler et sa périphérie définit une ouverture qui s'étend autour de l'élément à encapsuler, et
- une position de fermeture dans laquelle la périphérie de la membrane d'encapsulation est en appui sur le support pour obstruer cette ouverture.

15. Procédé selon la revendication 14, dans lequel le procédé comprend la modification (46) de la température du bras attachant la membrane d'encapsulation au support pour qu'en réponse ce bras déplace la membrane d'encapsulation entre ses positions de fermeture et d'ouverture.

16. Procédé selon la revendication 14 ou 15, dans lequel le procédé comprend :
- la réalisation (30) de l'élément à encapsuler sur le support,
- le dépôt (32) d'une couche sacrificielle sur l'élément, puis
- la réalisation (42) de la membrane d'encapsulation sur la couche sacrificielle, puis
- le retrait (44) de la couche sacrificielle pour créer la microcavité dans laquelle est reçu l'élément et,
- avant ou au cours du retrait de la couche sacrificielle, le déplacement (44) de la membrane d'encapsulation vers sa position d'ouverture pour faciliter le retrait de la couche sacrificielle, et
- après le retrait de la couche sacrificielle, l'action de courber le bras pour déplacer (46) la membrane d'encapsulation vers sa position de fermeture.

## Claims

1. Device for encapsulating an element inside a microcavity prepared on a support (10), this device comprising an encapsulation membrane (12; 60; 70; 110) capable of closing at least one part of the microcavity, **characterized in that** the device comprises at least one arm mechanically attaching the membrane to the support, this arm being capable of getting curved to shift the membrane between:
- an open position in which the membrane overhangs the element to be encapsulated and its periphery defines an aperture that extends around the element to be encapsulated, and
- a closed position in which the periphery of the encapsulation membrane is supported on the support to obstruct this aperture.

2. Device according to claim 1, wherein the membrane defines the roof of the microcavity in the closed position.

3. Device according to claim 1 or 2 wherein the device furthermore comprises actuation means (14-16; 62; 72; 90; 116-119) associated in part with the membrane (12; 60; 70; 110) and in part with the support (10) to enable the shifting of the membrane between its open and closed positions.

4. Device according to claim 3, wherein the actuation means (14-16; 62; 72; 90; 116-119) are chosen from among thermal, electrostatic, electromagnetic or piezoelectric means, singly or in combination.

5. Device according to claim 4, wherein the thermal actuation means comprise at least the arm (14-16; 62; 90; 116-119) attaching the encapsulation membrane (12; 60; 70; 110) to the support, this arm comprising at least two at least partly superimposed layers (22, 24) made out of materials, the expansion coefficients of which are different so that, in response to a temperature variation, this arm gets curved and causes the shifting of the encapsulation membrane between its open and closed positions and vice versa.

6. Device according to any one of the above claims, wherein the encapsulation membrane (12; 110) comprises at least two superimposed layers (22, 24; 112, 114) made out of materials, the expansion coefficients of which are chosen so that, at a temperature of use, the encapsulation membrane is domed so as to define a lateral wall and a roof of the microcavity in which the element is received.

7. Device according to any one of the above claims, wherein the encapsulation membrane comprises at least two superimposed layers made out of materials, at least one of which has piezoelectric properties to enable the encapsulation membrane, for a given difference in potentials applied to said material, to be domed so as to define a lateral wall and a roof of the microcavity in which the element is received.

8. Device according to claim 6 or 7, wherein the material of the layer (22) of the encapsulation membrane (10) in contact with the microcavity is moreover a getter material.

9. Device according to any one of the claims 5 to 8, wherein the device comprises at least one electrode for heating the arm and/or the encapsulation membrane, fixedly joined to the support.

10. Device according to claim 9, wherein:
- at least one of the layers (92) of the arm and/or of the encapsulation membrane, made out of a material having an expansion coefficient different from that of the materials of the other layers, is a resistive material capable of dissipating electrical energy in the form of heat when it is crossed by a current, this layer thus forming the heating electrode, and
- the device comprises conductive tracks (96) electrically connecting the layer made out of resistive material to connection terminals of a current source.

11. Device according to any one of the claims 6 to 10, wherein the encapsulation membrane (12) has a circular edge (18) centred on an axis (20) of revolution and the layers (22, 24) of the encapsulation membrane accept this axis of revolution as an axis of rotational symmetry.

12. Device according to any one of the claims 6 to 10, wherein the encapsulation membrane (110) has a polygonal edge and at least one of the layers (114) of the encapsulation membrane is made out of:
- an anisotropic material having coefficients of expansion or piezoelectric properties along different directions of the plane of the membrane, or
- a material that is non-uniformly distributed within said layer,
this material being laid out in the layer so that the polygonal edge of the encapsulation membrane is in a plane in the closed position.

13. Microcapsule comprising an element (6) received inside a microcavity (4), **characterized in that** the microcapsule also has an encapsulation device (8) according to any one of the above claims.

14. Method for encapsulating an element inside a microcavity prepared on a support, **characterized in that** the method comprises the action of curving (46) at least one arm mechanically attaching an encapsulation membrane to the support to shift the encapsulation membrane between:
- an open position in which the membrane overhangs the element to be encapsulated and its periphery defines an aperture that extends around the element to be encapsulated, and
- a closed position in which the periphery of the encapsulation membrane is supported on the support to obstruct this aperture.

15. Method according to claim 14, wherein the method comprises the modification (46) of the temperature of the arm attaching the encapsulating membrane to the support so that, in response, this arm shifts the encapsulation membrane between its closed and open positions.

16. Method according to claim 14 or 15, wherein the method comprises:
- the making (30) of the element to be encapsulated on the support,
- the depositing (32) of a sacrificial layer on the element, then,
- the making (42) of the encapsulation membrane on the sacrificial layer, then
- the withdrawal (44) of the sacrificial layer to create the microcavity in which the element is received and,
- before or during the withdrawal of the sacrificial layer, the shifting (44) of the encapsulating membrane towards its open position to facilitate the withdrawal of the sacrificial layer, and
- after the withdrawal of the sacrificial layer, the action of curving the arm to shift (46) the encapsulation membrane towards its closed position.

## Patentansprüche

1. Verkapselungsvorrichtung eines Elements im Innern einer Mikroausnehmung, die auf einem Träger (10) ausgespart ist, wobei diese Vorrichtung eine Verkapselungsmembran (12; 60; 0; 110) umfasst, die geeignet ist, wenigstens einen Teil der Mikroausnehmung zu schließen,
**dadurch gekennzeichnet, dass** die Vorrichtung wenigstens einen Arm umfasst, der die Membran mechanisch am Träger befestigt, wobei dieser Arm geeignet ist, sich zu krümmen, um die Membran zu verschieben zwischen:
- einer Öffnungsposition, in der die Membran das zu verkapselnde Element überragt und seine Peripherie eine Öffnung definiert, die sich um das zu verkapselnde Element erstreckt, und
- einer Verschlussposition, in der die Peripherie der Verkapselungsmembran sich auf dem Träger aufstützt, um diese Öffnung zu verschließen.

2. Vorrichtung gemäß Anspruch 1, in der die Membran das Dach der Mikroausnehmung in der Verschlussposition definiert.

3. Vorrichtung gemäß Anspruch 1 oder 2, in der die Vorrichtung darüber hinaus Betätigungsmittel (14-16 ; 62 ; 72 ; 90 ; 116-119) umfasst, die zum Teil der Membran (12 ; 60 ; 70 ; 110) und zum Teil dem Träger (10) zugeordnet sind, um die Verschiebung der Membran zwischen ihren Öffnungs- und Verschlusspositionen zu erlauben.

4. Vorrichtung gemäß Anspruch 3, in der die Betätigungsmittel (14-16 ; 62 ; 72 ; 90 ; 116-119)aus thermischen, elektrostatischen, elektromagnetischen oder piezoelektrischen Mitteln, allein oder in Kombination, ausgewählt sind.

5. Vorrichtung gemäß Anspruch 4, in der die Mittel zur thermischen Betätigung wenigstens den Arm (14-16 ; 62 ; 90 ; 116-119) umfassen, der die Verkapselungsmembran (12 ; 60 ; 70 ; 110) am Träger befestigt, wobei dieser Arm wenigstens zwei Schichten (22, 24) umfasst, die wenigstens zum Teil überlagert sind und aus den Materialien realisiert sind, deren Ausdehnungskoeffizienten unterschiedlich sind, damit dieser Arm als Reaktion auf eine Temperaturschwankung sich krümmt und die Verschiebung der Verkapselungsmembran zwischen ihren Öffnungs- und Verschlusspositionen nach sich zieht.

6. Vorrichtung gemäß einem der vorhergehenden Ansprüche, in der die Verkapselungsmembran (12; 110) wenigstens zwei überlagerte Schichten (22, 24 ; 112, 114) umfasst, die aus Material realisiert sind, deren Ausdehnungskoeffizienten ausgewählt sind, damit die Verkapselungsmembran bei einer Nutzungstemperatur derart gewölbt ist, dass sie eine Seitenwand und ein Dach der Mikroausnehmung definiert, in der das Element aufgenommen ist.

7. Vorrichtung gemäß einem der vorhergehenden Ansprüche, in der die Verkapselungsmembran wenigstens zwei überlagerte Schichten umfasst, die aus Material realisiert sind, von dem wenigstens eines piezoelektrische Eigenschaften aufweist, um bei einer bestimmten Potenzialdifferenz, die auf das genannte Material angewendet wird, es zu ermöglichen, dass die Verkapselungsmembran derart gewölbt ist, dass sie eine Seitenrand und ein Dach der Mikroausnehmung definiert, in der das Element aufgenommen ist.

8. Vorrichtung gemäß Anspruch 6 oder 7, in der das Material der Schicht (22) der Verkapselungsmembran (10), das mit der Mikroausnehmung in Kontakt ist, darüber hinaus ein Gas fixierendes Material ist.

9. Vorrichtung gemäß Anspruch 5 bis 8, in der die Vorrichtung wenigstens eine Heizelektrode des Arms und / oder der Verkapselungsmembran umfasst, die fest mit dem Träger verbunden ist.

10. Vorrichtung gemäß Anspruch 9, in der:
- wenigstens eine der Schichten (92) des Arms und / oder der Verkapselungsmembran, die aus einem Material realisiert ist, das einen vom Material der anderen Schichten unterschiedlichen Ausdehnungskoeffizienten aufweist, ein resistives, zum Abführen einer elektrischen Energie in Form von Wärme geeignetes Material ist, wenn es von einem Strom durchlaufen wird, wobei diese Schicht somit die Heizelektrode bildet, und
- die Vorrichtung Leiterbahnen (96) umfasst, die die Schicht aus resistivem Material an Anschlussklemmen einer Stromquelle elektrisch anschließt.

11. Vorrichtung gemäß Anspruch 6 bis 10, in der die Verkapselungsmembran (12) einen kreisförmigen Rand (18) aufweist, der auf einer Revolutionsachse (10) zentriert ist, und die Schichten (22, 24) der Verkapselungsmembran diese Revolutionsachse als Rotations-Symmetrieachse zulassen.

12. Vorrichtung gemäß einem der vorhergehenden Anspruch 6 bis 10, in der die Verkapselungsmembran (110) einen polygonalen Rand aufweist und wenigstens eine der Schichten (114) der Verkapselungsmembran realisiert ist durch:
- ein anisotropes Material, das Ausdehnungskoeffizienten oder piezoelektrische Eigenschaften aufweist, die je nach den verschiedenen Richtungen der Ebene der Membran unterschiedlich sind, oder
- ein nicht gleichmäßig im Innern der genannten Schicht verteiltes Material,
wobei dieses Material derart in der Schicht angeordnet ist, dass der polygonale Rand der Verkapselungsmembran sich in einer Ebene in der Verschlussposition befindet.

13. Ein im Innern einer Mikroausnehmung (4) aufgenommenes Element enthaltende Mikrokapsel, **dadurch gekennzeichnet, dass** die Mikrokapsel ebenfalls eine Verkapselungsvorrichtung (8) gemäß einem der vorhergehenden Ansprüche umfasst.

14. Verkapselungsverfahren eines Elements im Innern einer auf einem Träger ausgesparten Mikroausnehmung, **dadurch gekennzeichnet, dass** dieses Verfahren die Aktion des Krümmens (46) wenigstens eines Arms umfasst, der eine Verkapselungsmembran mechanisch am Träger befestigt, um die Verkapselungsmembran zu verschieben zwischen:
- einer Öffnungsposition, in der die Membran das zu verkapselnde Element überragt und seine Peripherie eine Öffnung definiert, die sich um das zu verkapselnde Element erstreckt, und
- einer Verschlussposition, in der die Peripherie der Verkapselungsmembran sich auf dem Träger aufstützt, um diese Öffnung zu verschließen.

15. Verfahren gemäß Anspruch 14, in dem das Verfahren die Änderung (46) der Temperatur des Arms umfasst, der die Verkapselungsmembran am Träger befestigt, damit dieser Arm als Reaktion die Verkapselungsmembran zwischen ihren Verschluss- und Öffnungspositionen verschiebt.

16. Verfahren gemäß Anspruch 14 oder 15, in dem das Verfahren umfasst:
- die Realisierung (30) des auf dem Träger zu verkapselnden Elements,
- die Ablage (32) einer Opferschicht auf dem Element, dann
- die Realisierung (42) der Verkapselungsmembran auf der Opferschicht, dann
- die Abnahme (44) der Opferschicht, um eine Mikroausnehmung zu schaffen, in der das Element aufgenommen ist, und
- vor oder während der Abnahme der Opferschicht die Verschiebung (44) der Verkapselungsmembran in ihre Öffnungsposition, um die Abnahme der Opferschicht zu erleichtern, und
- nach der Abnahme der Opferschicht die Aktion des Krümmens des Arms, um die Verkapselungsmembran in ihre Verschlussposition zu verschieben (46).
